(19) Europäisches Patentamt
European Patent Office
Office européen des brevets

(11) **EP 3 001 524 B1**

(12) **FASCICULE DE BREVET EUROPEEN**

(45) Date de publication et mention
de la délivrance du brevet:
**10.01.2018 Bulletin 2018/02**

(51) Int Cl.:
*H02H 3/16* (2006.01)         *G01R 31/08* (2006.01)
*H02H 3/38* (2006.01)         *H02H 3/40* (2006.01)
*G01R 25/00* (2006.01)

(21) Numéro de dépôt: **15187143.1**

(22) Date de dépôt: **28.09.2015**

(54) **DÉTECTION DIRECTIONNELLE DE DÉFAUT TERRE DANS UN RÉSEAU DE DISTRIBUTION ÉLECTRIQUE**

RICHTUNGSERFASSUNG DES MASSESCHLUSSES IN EINEM STROMVERTEILUNGSNETZ

DIRECTIONAL DETECTION OF A GROUND FAULT IN AN ELECTRICAL DISTRIBUTION NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.09.2014 FR 1459194**

(43) Date de publication de la demande:
**30.03.2016 Bulletin 2016/13**

(73) Titulaire: **Schneider Electric Industries SAS
92500 Rueil-Malmaison (FR)**

(72) Inventeurs:
• **DROUERE, Bernard**
  **38050 Grenoble Cedex 9 (FR)**
• **MECREANT, Julien**
  **38050 Grenoble Cedex 9 (FR)**

(74) Mandataire: **Brevalex
95, rue d'Amsterdam
75378 Paris Cedex 8 (FR)**

(56) Documents cités:
EP-A1- 2 533 060      EP-A2- 2 306 609
US-A- 5 661 664       US-A1- 2010 301 872

## Description

## DOMAINE TECHNIQUE

La présente invention concerne la détection directionnelle d'un défaut à la terre dans un réseau de distribution électrique. Elle vise à détecter un défaut à la terre et à déterminer si le défaut détecté est localisé en amont ou en aval du point de détection.

## ÉTAT DE LA TECHNIQUE ANTÉRIEURE

Les dispositifs de détection de défaut à la terre sont notamment utilisés dans les réseaux de distribution électrique triphasés.

Le document EP 0 591 011 propose un dispositif de détection de défauts sur un réseau de distribution d'énergie électrique souterrain. Ce dispositif effectue une détection des variations transitoires du courant homopolaire en comparant le signe du courant homopolaire à celui de la tension homopolaire.

Cette technique demande une fréquence d'échantillonnage élevée pour garantir une bonne détection de sens, dans les premières millisecondes suivant l'apparition du défaut terre dans les réseaux à neutre compensé, sur les indicateurs de passage défaut (IPD) en aval du défaut.

Le document EP 0 845 846 propose un dispositif de détection de défaut sur lignes d'alimentation électrique. Ce dispositif compare le signe des transitoires de tension homopolaire avec le signe de l'intégrale des transitoires de courant homopolaire. Cette technique demande une fréquence d'échantillonnage élevée pour garantir une bonne détection de sens, dans le premier quart de période suivant l'apparition du défaut terre dans les réseaux à neutre compensé, sur les IPD en aval du défaut.

Le document EP 2 624 397 propose un dispositif de détection de la direction d'un défaut (phase/terre ou entre phases) dans un réseau électrique triphasé.

Ce dispositif utilise une somme cumulative de vecteurs représentatifs de grandeurs électriques telles qu'impédance, admittance, puissance ou courant, éventuellement représentées par leurs composantes symétriques. Pour les défauts phase/terre, la composante homopolaire des grandeurs électriques impédance, admittance, puissance, tension et courant est utilisée. Le vecteur est constitué soit de la TFD (Transformée de Fourier Discrète) de la composante fondamentale, soit de la somme des TFD des harmoniques.

La plupart des relais de protection utilisent les TFD du courant résiduel et de la tension résiduelle, à la fréquence fondamentale du réseau, pour réaliser une projection du courant résiduel sur une tension de polarisation élaborée à partir de la tension résiduelle et d'un angle caractéristique, adapté au régime de neutre.

La partie réelle du courant projeté est comparée à un seuil Iso, négatif pour les défauts en aval du relais de protection et positif pour les défauts en amont du relais de protection.

Cette technique demande soit à adapter l'angle caractéristique au régime de neutre, soit à mettre en oeuvre autant d'instances que de régimes de neutre (compensé et/ou isolé, comme en Italie).

Lorsque l'angle caractéristique est égal à 0°, la partie réelle de la projection est communément définie comme le courant actif; lorsqu'il est égal à 90°, c'est le courant réactif.

Cette technique présente l'inconvénient de ne pas assurer le maintien du bit instantané dans la première période du réseau électrique (IR projeté > Iso), dans les réseaux à neutre compensé et isolé, sur les IPD en aval du défaut.

US 5 661 664 concerne la localisation de défaut sur une ligne électrique, sur la base de phaseurs de courant et de tension mesurés à une extrémité de la ligne.

US 2010-301872 concerne la détermination d'une valeur de réglage d'un dispositif de protection électrique. Cette détermination utilise des phaseurs de courant et de tension.

EP 2 533 060 concerne la détection de défaut terre sur un réseau de distribution électrique.

EP 2 306 609 concerne la détection de défaut terre et comporte la détermination de phaseurs de courant et de tension.

## EXPOSÉ DE L'INVENTION

L'invention vise à résoudre les problèmes de la technique antérieure en fournissant un procédé de détermination directionnelle d'un défaut à la terre dans un réseau de distribution électrique, comportant les étapes de :

Détermination d'un phaseur de courant résiduel,
Détermination d'un phaseur de tension résiduelle,
caractérisé en ce qu'il comporte les étapes de :

Détermination d'un courant actif par projection du phaseur de courant résiduel sur le phaseur de tension résiduelle,
Détermination du module de phaseur de tension résiduelle,
Comparaison du module de phaseur de tension résiduelle avec un seuil (SVR),
et en ce qu'il comporte les étapes suivantes, tant que le module de phaseur de tension résiduelle reste supérieur au seuil ou à une fraction du seuil, et pour un nombre prédéterminé d'itérations à partir du moment où le module de phaseur de tension résiduelle est supérieur au seuil :

Détermination de l'intégrale du courant actif et du signe de l'intégrale du courant actif,
Détermination du module du phaseur de courant résiduel,

Détermination du nombre de fois où le module du phaseur de courant résiduel est supérieur à un seuil prédéterminé, au cours du nombre prédéterminé d'itérations,

Si le module du phaseur de courant résiduel est supérieur au seuil prédéterminé (SIR) au moins une fois, au cours du nombre prédéterminé d'itérations,

Détermination de la localisation amont ou aval du défaut en fonction du nombre de fois où le signe de l'intégrale du courant actif a été positif ou négatif au cours du nombre prédéterminé d'itérations.

Grâce à l'invention, la détection directionnelle d'un défaut à la terre n'est pas spécifique à une configuration particulière de réseau ou à différents paramètres du réseau. Ainsi, la détection directionnelle de défaut à la terre est utilisable :

- sur tous les régimes de neutre, par exemple isolé, par impédance de limitation, par impédance de compensation avec ou sans courant actif,
- sur les réseaux électriques de distribution de tension inférieure ou égale à 50 kV, dits HTA, en coupure d'artères ou bouclés, dont la mise à terre est unique ou distribuée, ainsi que sur les réseaux électriques de distribution multisources,
- sans réglage avancé pour l'utilisateur (notamment pas d'angle caractéristique).

La détection directionnelle de défaut à la terre selon la présente invention facilite la mise en oeuvre par un exploitant de base et s'adapte au changement de régime de neutre en cas de changement de schéma d'exploitation.

L'invention propose un procédé de détection directionnelle de défaut à la terre applicable aux relais de protection, mais tout particulièrement aux Indicateurs de Passage Défaut (IPD), qui ne disposent pas de capteurs précis.

L'invention propose de déterminer le sens du défaut dans la phase transitoire, non pas sur les échantillons comme le propose le document EP 0 845 846, mais à partir de la projection du phaseur du courant résiduel sur le phaseur de la tension résiduelle, en intégrant la partie réelle de la projection pendant la phase transitoire.

L'intérêt majeur de déterminer le sens du défaut dans la phase transitoire est qu'il n'y a pas à régler l'angle caractéristique de la projection en fonction du régime de neutre du réseau électrique. En effet dans la phase transitoire du défaut terre, le réseau se comporte comme un réseau à neutre isolé.

Selon une caractéristique préférée, le nombre et la fréquence des itérations sont choisis en fonction d'un découpage de la période du réseau de distribution électrique de sorte que les itérations sont effectuées sur une période réseau.

Selon une caractéristique préférée, le courant actif est calculé selon la formule :

$$Iactif = \frac{R\acute{e}el(\overrightarrow{IR} \times \overrightarrow{VR}*)}{\left\|\overrightarrow{VR}\right\|}$$

où $\overrightarrow{VR}$ représente le phaseur de tension résiduelle, $\left\|\overrightarrow{VR}\right\|$ le module du phaseur de tension résiduelle et $\overrightarrow{IR}$ le phaseur de courant résiduel.

Selon une caractéristique préférée, l'intégrale du courant actif est calculée en sommant les valeurs de courant actif un nombre de fois égal au nombre prédéterminé d'itérations.

L'invention concerne aussi un procédé de protection d'une ligne de courant lors de l'apparition d'un défaut terre, caractérisé en ce qu'il comporte l'actionnement d'un dispositif de coupure de la ligne sur laquelle un défaut terre a été détecté par le procédé de détermination directionnelle d'un défaut à la terre tel que précédemment présenté.

L'invention concerne encore un dispositif de détermination directionnelle d'un défaut à la terre dans un réseau de distribution électrique, comportant :

Des moyens de détermination d'un phaseur de courant résiduel,
Des moyens de détermination d'un phaseur de tension résiduelle,
caractérisé en ce qu'il comporte :

Des moyens de détermination d'un courant actif par projection du phaseur de courant résiduel sur le phaseur de tension résiduelle,
Des moyens de détermination du module de phaseur de tension résiduelle,
Des moyens de comparaison du module de phaseur de tension résiduelle avec un seuil,
et en ce qu'il comporte les moyens suivants, aptes à fonctionner tant que le module de phaseur de tension résiduelle reste supérieur au seuil ou à une fraction du seuil, et pour un nombre prédéterminé d'itérations à partir du moment où le module de phaseur de tension résiduelle est supérieur au seuil :

Des moyens de détermination de l'intégrale du courant actif et du signe de l'intégrale du courant actif,
Des moyens de détermination du module du phaseur de courant résiduel,
Des moyens de détermination du nombre de fois où le module du phaseur de courant résiduel est supérieur à un seuil prédéterminé, au cours du nombre prédéterminé d'itérations,
Des moyens de détermination de la localisation amont ou aval du défaut en fonction du nombre de fois où le signe de l'intégrale du courant actif a été positif ou négatif au cours du nombre prédéterminé d'itérations, si le module du phaseur de courant résiduel est supérieur au seuil prédéterminé au moins une fois, au cours du nombre prédéterminé d'itérations.

L'invention concerne aussi un indicateur de passage de défaut à la terre caractérisé en ce qu'il comporte le dispositif précédemment présenté.

L'invention concerne aussi un dispositif de protection d'une ligne de courant lors de l'apparition d'un défaut terre, caractérisé en ce qu'il comporte des moyens d'actionnement d'un dispositif de coupure de la ligne sur laquelle un défaut terre a été détecté par le dispositif de détermination directionnelle d'un défaut à la terre précédemment présenté.

Le procédé de protection, le dispositif de détermination, l'indicateur de passage de défaut à la terre, le dispositif de protection présentent des avantages analogues à ceux précédemment présentés.

Dans un mode particulier de réalisation, les étapes du procédé selon l'invention sont mises en oeuvre par des instructions de programme d'ordinateur.

En conséquence, l'invention vise aussi un programme d'ordinateur sur un support d'informations, ce programme étant susceptible d'être mis en oeuvre dans un ordinateur, ce programme comportant des instructions adaptées à la mise en oeuvre des étapes d'un procédé tel que décrit ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions de programme d'ordinateur adaptées à la mise en oeuvre des étapes d'un procédé tel que décrit ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé selon l'invention.

## BRÈVE DESCRIPTION DES DESSINS

D'autres caractéristiques et avantages apparaîtront à la lecture de la description suivante d'un mode de réalisation préféré donné à titre d'exemple non limitatif, décrit en référence aux figures dans lesquelles :

La figure 1 représente des réseaux de distribution électrique équipés de dispositifs de détection directionnelle de défaut à la terre, selon la présente invention,
La figure 2 représente un dispositif de détection directionnelle de défaut à la terre, selon un mode de réalisation de la présente invention,
La figure 3 représente un procédé de détection directionnelle de défaut à la terre, selon un mode de réalisation de la présente invention,
La figure 4 représente un dispositif de détection directionnelle de défaut à la terre, selon un mode de réalisation de la présente invention.

## EXPOSÉ DÉTAILLÉ DE MODES DE RÉALISATION PARTICULIERS

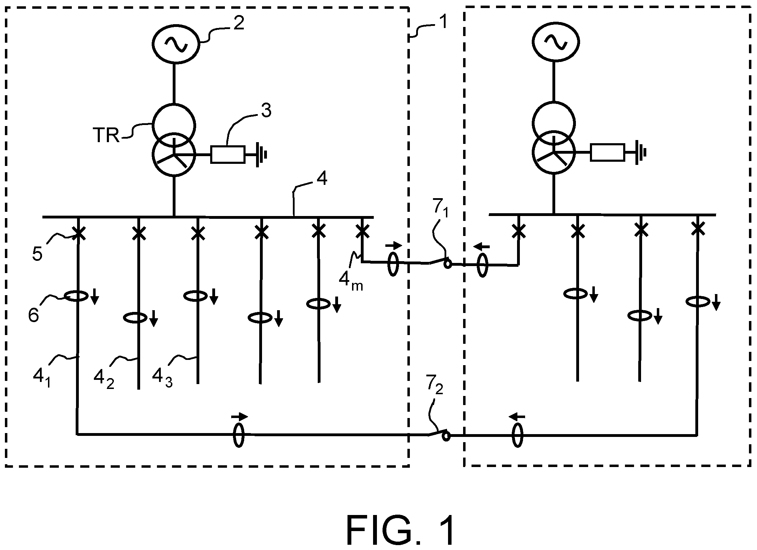

Selon un mode de réalisation préféré représenté à la **figure 1,** des dispositifs 6 de détection directionnelle de défaut à la terre sont mis en oeuvre dans un premier réseau de distribution électrique haute tension 1.

Le réseau de distribution électrique 1 comporte une source de tension 2 reliée au primaire d'un transformateur triphasé TR dont le secondaire peut comporter un conducteur commun de neutre généralement connecté à la terre par une impédance 3.

Le secondaire du transformateur TR est par ailleurs connecté à une ligne principale de distribution 4 qui alimente un ensemble de m lignes de départ $4_1, 4_2, 4_3, ... 4_m$ qui peuvent respectivement comporter en tête un disjoncteur ou autre dispositif de coupure 5 les protégeant.

Les lignes de départ $4_1, ..., 4_m$ sont composées de lignes aériennes et/ou de câbles souterrains. Elles peuvent être sujettes à des défauts variés, qu'il est important de détecter et localiser afin de pallier les problèmes générés : rupture d'alimentation, dégradation de la tenue des matériels d'isolation, sans compter la sécurité des personnes. Ainsi, des dispositifs de détection de défaut 6 équipent les lignes de départ pour servir d'indicateur de passage de défaut. Les indicateurs de passage de défaut allument par exemple un voyant lumineux. Un dispositif peut par ailleurs être associé ou intégré à un relai de protection apte à commander l'ouverture des contacts du disjoncteur 5 de chacune des lignes $4_1$ à $4_m$.

Un indicateur de passage de défaut quelconque 6 détecte des défauts en amont ou en aval par rapport au sens d'écoulement de l'énergie avec la convention récepteur. Ce sens est symbolisé par une flèche située à côté de l'indicateur de passage de défaut.

Le réseau électrique 1 est relié à un second réseau électrique qui comporte des éléments analogues. Ainsi, la ligne $4_1$ est reliée à une ligne du second réseau électrique par l'intermédiaire d'un interrupteur $7_2$. De même, la ligne $4_m$ est reliée à une autre ligne du second réseau électrique par l'intermédiaire d'un second interrupteur $7_1$.

L'invention s'applique donc à des réseaux de distribution électrique multi sources, dont l'impédance de limitation à la terre est distribuée. Il s'agit de réseaux de distribution électrique en coupure d'artères ou bouclés.

Il est à noter que le réseau de distribution électrique peut aussi être relié à un site industriel.

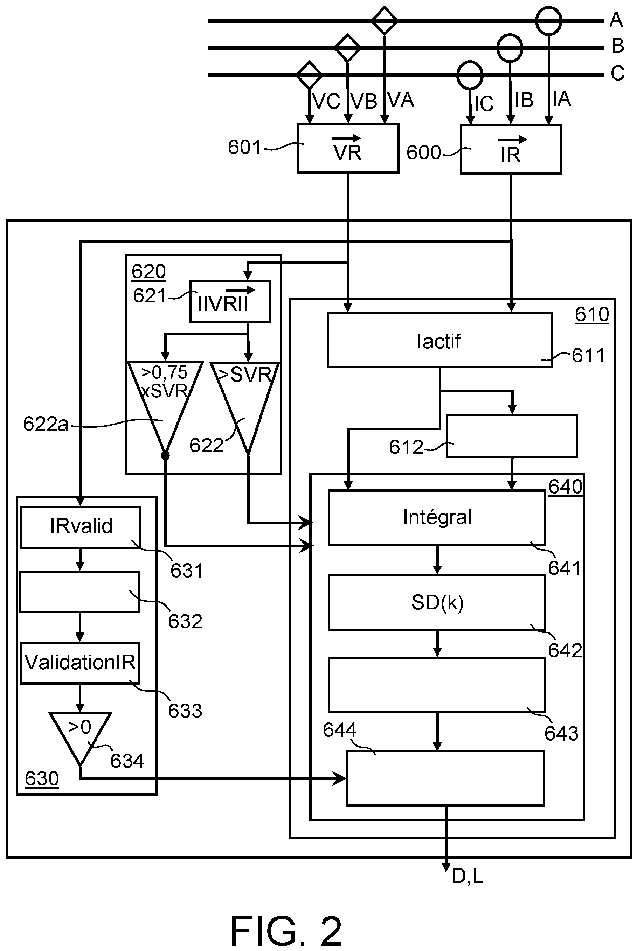

En référence à la **figure 2,** un dispositif de détection directionnelle de défaut à la terre 6 équipe les trois phases d'une ligne du réseau de distribution électrique. A partir des trois phases, des capteurs de courant sont reliés à un module 600 de détermination de phaseur de courant résiduel $\overrightarrow{IR}$. Le phaseur de courant résiduel est obtenu par mesure directe, par exemple par un tore homopolaire, ou par sommation des mesures des trois courants de phase IA, IB, et IC.

Toujours à partir des trois phases, des capteurs de tension sont reliés à un module 601 de détermination de phaseur de tension résiduelle $\overrightarrow{VR}$. Le phaseur de tension résiduelle est obtenu par exemple par sommation des trois tensions phase-terre VA, VB, et VC. Les capteurs de tension ne nécessitent pas d'être d'une grande précision. Par exemple, il est possible d'utiliser des capteurs dits VPIS (Voltage Presence Indicator System).

Bien entendu, ces calculs impliquent une conversion analogique-numérique, un filtrage et un échantillonnage des mesures. Ces opérations sont classiques en soi et ne sont ni représentées ni décrites pour simplifier l'exposé.

Les calculs suivants sont effectués par cycle, chaque cycle correspondant préférentiellement à un quart de période réseau.

Les sorties des modules 600 et 601 sont reliées à des entrées d'un module de calcul 610.

La sortie du module 601 de détermination de phaseur de tension résiduelle $\overrightarrow{VR}$ est également reliée à une entrée d'un module de contrôle de tension 620.

La sortie du module 600 de détermination de phaseur de courant résiduel $\overrightarrow{IR}$ est également reliée à une entrée d'un module de contrôle de courant 630.

Le fonctionnement du module de calcul 610, du module de contrôle de tension 620 et du module de contrôle de courant 630 est le suivant.

Le module de contrôle de tension 620 comporte un sous-module 621 de détermination du module de phaseur de tension résiduelle $\overrightarrow{VR}$ relié à un sous module 622 de vérification si le module du phaseur de tension résiduelle $\overrightarrow{VR}$ est supérieur à un seuil SVR. Le seuil SVR sert à déclencher les calculs de détection de défaut terre et de localisation du défaut par rapport au dispositif. Ainsi, la fenêtre d'observation pour la détection de défaut est ouverte par la tension. Le seuil SVR est par exemple choisi entre 2 kV et 4 kV. De préférence, une hystérésis de 25 % est prise en compte. Dans ce cas, un sous module 622a de vérification si le module de phaseur de tension résiduelle $\overrightarrow{VR}$ est supérieur à 0,75 fois le seuil SVR est relié en parallèle du sous-module 622.

Comme on le verra, les calculs sont effectués itérativement. Lors d'un premier calcul, le seuil SVR est pris en compte. Pour un nombre déterminé d'itérations suivantes, après que le module du phaseur de tension résiduelle $\overrightarrow{VR}$ est supérieur au seuil SVR, c'est le seuil 0,75.SVR qui est pris en compte, et ce tant que le module du phaseur de tension résiduelle $\overrightarrow{VR}$ est supérieur à 0,75 fois le seuil SVR.

De préférence, le nombre total d'itérations des calculs, à partir du moment où le module du phaseur de tension résiduelle $\overrightarrow{VR}$ est supérieur au seuil SVR, est cinq. Tant que le module du phaseur de tension résiduelle $\overrightarrow{VR}$ est supérieur à 0,75 fois le seuil SVR, les cinq itérations s'enchainent. Sinon, le compte d'itération revient à zéro jusqu'à ce que le module du phaseur de tension résiduelle $\overrightarrow{VR}$ soit à nouveau supérieur au seuil SVR.

Une itération, ou cycle, de calcul est effectué(e) préférentiellement tous les quarts de période réseau.

Bien entendu, il est possible de choisir un autre coefficient multiplicateur, compris entre 0 et 1, du seuil SVR pour prendre en compte l'hystérésis. Il est aussi possible de ne pas prendre en compte d'hystérésis et donc de considérer le seuil SVR à toutes les itérations.

La sortie du sous-module 622 et la sortie du sous-module 622a sont reliées à un sous-module 640 du module 610, qui sera décrit dans la suite. Ces sorties activent le sous-module 640 lorsque le module de phaseur de tension résiduelle $\overrightarrow{VR}$ est supérieur au seuil SVR ou à 0,75 fois le seuil SVR, comme exposé plus haut.

Le module 610 comporte en entrée un sous-module 611 de calcul du courant *Iactif,* selon la formule :

$$Iactif = \frac{R\acute{e}el(\overrightarrow{IR} \times \overrightarrow{VR^*})}{\left\|\overrightarrow{VR}\right\|}$$

La sortie du sous-module 611 est reliée à l'entrée d'une mémoire 612 de type FIFO à cinq valeurs, chaque valeurs étant réactualisée préférentiellement tous les quarts de période réseau. Le résultat de ce calcul est mémorisé dans la mémoire 612.

Les sorties du sous-module 611 et de la mémoire 612 sont reliée au sous-module 640.

Lorsque le module 620 active le sous-module 640, celui-ci continue la suite du traitement. Pour cela, il comporte en entrée un sous-module 641 de calcul d'une variable notée *Intégral,* selon les formules suivantes :

(1) $Int\acute{e}gral = \sum_1^5 Iactif$ , pour le premier passage

(2) *Intégral = Intégral + Iactif,* pour les quatre passages suivants

Il est à noter que pour le premier passage, le calcul de la variable *Intégral* prend en compte les transitoires dans la période réseau précédant la détection du module du phaseur de tension résiduelle $\overrightarrow{VR}$ comme supérieur au seuil SVR.

La sortie du sous-module 641 est reliée à l'entrée d'un sous-module 642 de calcul d'une variable *SD(k)* représentant le sens du défaut, selon la formule suivante :

$$SD(k) = signe(Intégral)$$

La variable SD(k) vaut -1 si le signe de la variable *Intégral* est négatif et vaut 1 s'il est positif. La variable *k* représente le nombre d'itérations de calcul à partir du moment où le module du phaseur de tension résiduelle $\overrightarrow{VR}$ est supérieur au seuil SVR. La variable *k* varie donc entre 1 et 5, selon le mode de réalisation décrit.

La sortie du sous-module 642 est reliée à l'entrée d'une mémoire 643 de type FIFO à cinq valeurs, chaque valeurs étant réactualisée préférentiellement tous les quarts de période réseau. La variable *SD(k)* précédemment calculée est mémorisée dans la mémoire 643.

La sortie de la mémoire 643 est reliée à l'entrée d'un sous-module 644 qui sera décrit dans la suite.

Le module de contrôle de courant 630 reçoit les valeurs du phaseur de courant résiduel $\overrightarrow{IR}$ et comporte un sous-module 631 de calcul d'une variable binaire *IRvalid,* selon la formule :

$$IRvalid = \left( \left\| \overrightarrow{IR} \right\| > SIR \right)$$

Où SIR est un seuil de courant.

Cette formule signifie que la variable binaire *IRvalid* vaut 1 si le seuil SIR est dépassé, et 0 sinon.

La variable *IRvalid* est initialisée à la valeur 0 préalablement à tout calcul et lorsque le module du phaseur de tension résiduelle devient inférieur à 0.75 fois le seuil SVR.

La détection du défaut est validée si le module du phaseur du courant résiduel est supérieur au seuil SIR, au moins une fois au cours des cinq itérations. Le seuil SIR est par exemple choisi entre 1 A et 5 A.

La sortie du sous-module 631 est reliée à l'entrée d'une mémoire 632 de type FIFO à cinq valeurs, chaque valeur étant réactualisée tous les quarts de période réseau. La variable *IRvalid* précédemment calculée est mémorisée dans la mémoire 632.

La sortie de la mémoire 632 est reliée à l'entrée d'un sous-module 633 de calcul d'une variable *ValidationIR* qui est significative d'une détection effective d'un courant de défaut au cours des cinq derniers cycles, selon la formule :

$$ValidationIR = \sum_{5} IRvalid$$

La variable *ValidationIR* est la somme des variables *IRvalid* calculées sur les cinq derniers cycles.

La sortie du sous-module 633 est reliée à l'entrée d'un sous-module 634 de comparaison de la variable *ValidationIR* avec zéro.

Si la variable *ValidationIR* est strictement positive, alors le sous-module 634 transmet un ordre d'activation au sous-module 644.

Le sous-module 644 calcule la somme des variables *SD(k)* calculées et mémorisées sur les cinq derniers cycles. Le sous-module 644 effectue un test sur cette somme pour déterminer si elle est supérieure ou égale à 3 ou si elle est inférieure ou égale à -3, pour déterminer une information L de localisation de défaut terre.

Lorsque la somme est supérieure ou égale à 3, alors le sous-module 644 délivre une information indiquant que le défaut est en aval du dispositif.

Lorsque la somme est inférieure ou égale à -3, alors le sous-module 644 délivre une information indiquant que le défaut est en amont du dispositif.

Il est à noter que dans ces deux cas précédents, une information de détection D est implicitement associée avec l'information de localisation L.

Dans les autres cas, le sous-module 644 ne délivre pas d'information de localisation de défaut terre.

La détermination du sens du défaut à la terre est effectuée en cinq cycles séparés d'un quart de période réseau, donc sur seulement la première période du réseau électrique suivant l'apparition du défaut.

Bien entendu, il est possible de choisir un autre nombre de cycles et une autre fréquence de réalisation des cycles de calculs, et s'assurant de préférence que la détermination est effectuée sur la période du réseau électrique suivant l'apparition du défaut. De manière générale, une période réseau est découpée en (C-1) cycles, avec C de préférence impair. Le nombre d'itérations est C et on mémorise C valeurs dans les différentes mémoires 612, 632 et 643. Le calcul de sommation du sous-module 633 est effectué sur C valeurs. Le calcul de sommation du sous-module 641 est effectué sur C valeurs. Le test effectué par le sous-module 644 est fait par rapport à l'entier supérieur à C/2.

Lorsqu'un défaut à la terre a été détecté sur l'une des lignes $4_1$ à $4_m$, le dispositif de coupure 5 de la ligne concernée est commandé pour être ouvert.

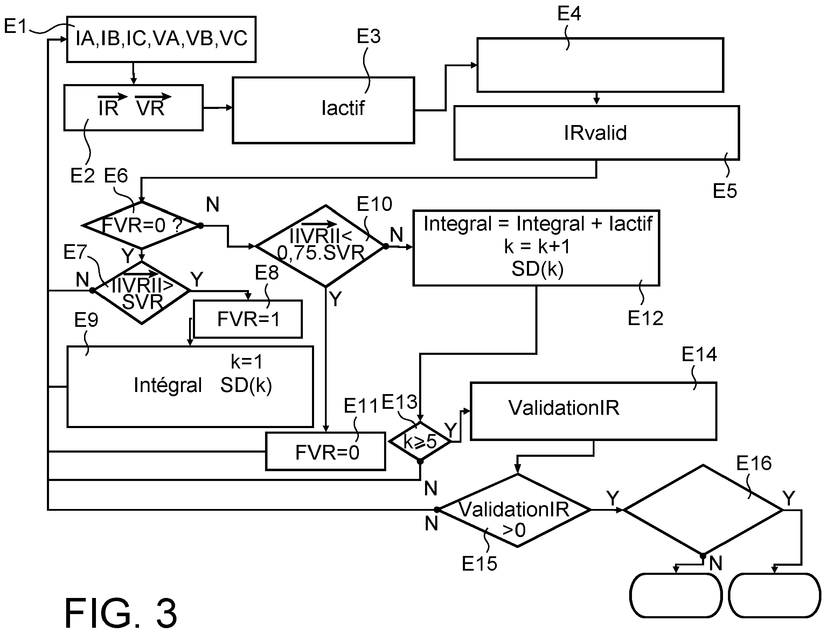

En référence à la **figure 3,** un procédé de de détection directionnelle de défaut à la terre mis en oeuvre dans le dispositif précédemment décrit comporte des étapes E1 à E16, pour le mode de réalisation préféré comportant cinq cycles séparés d'un quart de période réseau.

L'étape E1 est la mesure des trois courants de phase IA, IB, et IC et des trois tensions phase-terre VA, VB, et VC.

L'étape suivante E2 est la détermination du phaseur de courant résiduel $\overrightarrow{IR}$ et la détermination du phaseur de tension résiduelle $\overrightarrow{VR}$.

L'étape suivante E3 est le calcul du courant *Iactif,* selon la formule :

$$Iactif = \frac{R\acute{e}el(\overrightarrow{IR} \times \overrightarrow{VR}*)}{\left\| \overrightarrow{VR} \right\|}$$

L'étape suivante E4 est la mémorisation du résultat de ce calcul dans la mémoire 612 de type FIFO à cinq valeurs, chaque valeur étant réactualisée tous les quarts de période réseau.

L'étape suivante E5 est la détermination de la variable binaire *IRvalid,* selon la formule :

$$IRvalid = \left( \left\| \overrightarrow{IR} \right\| > SIR \right)$$

Où SIR est un seuil de courant.

La variable binaire *IRvalid* vaut 1 si le seuil SIR est dépassé, et 0 sinon.

A l'étape E5, la variable binaire *IRvalid* précédemment calculée est mémorisée dans la mémoire 632 de type FIFO à cinq valeurs, chaque valeur étant réactualisée tous les quarts de période réseau.

La détection du défaut est validée si le module du phaseur du courant résiduel est supérieur au seuil, au moins une fois au cours des cinq itérations. Le seuil SIR est par exemple choisi entre 1 A et 5 A.

L'étape E5 est suivie de l'étape E6, qui est un test pour déterminer si une variable d'état *FVR* vaut 0. La variable d'état *FVR* prend la valeur 0 ou 1. La variable d'état FVR est initialisée à la valeur 0 avant l'étape E1.

Si la variable d'état *FVR* vaut 0, l'étape E6 est suivie de l'étape E7 à laquelle le module du phaseur de tension résiduelle est calculé et comparé au seuil SVR.

Si le module du phaseur de tension résiduelle est inférieur ou égal au seuil SVR, alors l'étape E7 est suivie de l'étape E1 précédemment décrite.

Si le module du phaseur de tension résiduelle est supérieur au seuil SVR, alors l'étape E7 est suivie de l'étape E8 à laquelle la variable d'état *FVR* est mise à la valeur 1 pour indiquer ce dépassement de seuil.

L'étape E8 est suivie de l'étape E9, à laquelle la variable notée *Intégral* est calculée, selon la formule suivante :

$$Int\acute{e}gral = \sum_{1}^{5} Iactif$$

A l'étape E9, la variable *k* est initialisée à 1 et la variable *SD(k)* est mise à une valeur représentant le signe de la variable *Intégral* qui vient d'être calculée. La variable *SD(k)* représente la localisation du défaut. La variable *k* représente le nombre d'itérations de calcul à partir du moment où le module du phaseur de tension résiduelle $\overrightarrow{VR}$ est supérieur au seuil SVR. La variable *k* varie donc entre 1 et 5, selon le mode de réalisation décrit.

L'étape E9 est suivie de l'étape E1 précédemment décrite.

A l'étape E6, si la variable d'état *FVR* ne vaut pas 0, cela signifie que les étapes E7 à E9 ont déjà été parcourues. L'étape E6 est alors suivie de l'étape E10 à laquelle le module du phaseur de tension résiduelle est comparé à 0,75 fois le seuil SVR, pour prendre en compte un phénomène d'hystérésis. Bien entendu, il est possible de choisir un autre coefficient multiplicateur entre 0 et 1 du seuil SVR ou il est possible de ne pas appliquer de coefficient multiplicateur au seuil SVR.

Si le module du phaseur de tension résiduelle est inférieur ou égal à 0,75 fois le seuil SVR, alors le traitement est terminé. L'étape E10 est suivie de l'étape E11 à laquelle la variable *FVR* est mise à la valeur 0.

L'étape E11 est suivie de l'étape E1 précédemment décrite.

A l'étape E10, si le module du phaseur de tension résiduelle est supérieur à 0,75 fois le seuil SVR, alors l'étape E10 est suivie de l'étape E12 à laquelle la variable *Intégral* est mise à jour, selon la formule suivante :

$$Int\acute{e}gral = Int\acute{e}gral + Iactif$$

A l'étape E12, la variable *k* est augmentée de 1 et la variable *SD(k)* est mise à une valeur représentant le signe de la variable *Intégral* qui vient d'être calculée. La variable *SD(k)* représente la localisation du défaut.

L'étape E12 est suivie de l'étape E13 qui est un test pour déterminer si la variable *k* est supérieure ou égale à 5.

Lorsque la réponse est négative, cela signifie que moins de cinq itérations ont été effectuées depuis un premier dépassement de seuil SVR constaté à l'étape E7. L'étape E13 est alors suivie de l'étape E1 précédemment décrite.

Lorsque la réponse est positive à l'étape E13, cela signifie que cinq itérations ont été effectuées depuis un premier dépassement de seuil SVR constaté à l'étape E7. L'étape E13 est alors suivie de l'étape E14 qui est le calcul de la variable *ValidationIR* qui est significative d'une détection effective d'un courant de défaut au cours des cinq derniers cycles, selon la formule :

$$ValidationIR = \sum_{5} IRvalid$$

La variable *ValidationIR* est la somme des variables *IRvalid* calculées sur les cinq derniers cycles.

L'étape E14 est suivie de l'étape E15 qui est un test pour déterminer si la variable *ValidationIR* est supérieure à 0.

Lorsque la réponse est négative, cela signifie qu'un courant de défaut n'a pas été détecté sur les cinq derniers cycles. L'étape E15 est alors suivie de l'étape E1 précédemment décrite.

Lorsque la réponse est positive à l'étape E15, cela signifie qu'un courant de défaut a été détecté sur les cinq derniers cycles. L'étape E15 est alors suivie de l'étape E16 qui est un calcul de la somme des variables SD(k) calculées et mémorisées sur les cinq derniers cycles L'étape E16 comporte ensuite un test sur cette somme pour déterminer si elle est supérieure ou égale à 3 ou si elle est inférieure ou égale à -3, pour déterminer une information de localisation de défaut terre.

Lorsque la somme est supérieure ou égale à 3, alors l'étape E16 délivre une information indiquant que le défaut est en aval du dispositif.

Lorsque la somme est inférieure ou égale à -3, alors l'étape E16 délivre une information indiquant que le défaut est en amont du dispositif.

Il est à noter que dans ces deux cas précédents, une information de détection est implicitement associée avec l'information de localisation.

Dans les autres cas, l'étape E16 ne délivre pas d'information de localisation de défaut terre.

Dans l'exemple décrit, la détermination du sens du défaut à la terre est effectuée en cinq cycles séparés d'un quart de période réseau, donc sur seulement la première période du réseau électrique suivant l'apparition du défaut.

Comme exposé précédemment, il est possible de choisir un autre nombre de cycles et une autre fréquence de réalisation des cycles de calculs, et s'assurant de préférence que la détermination est effectuée sur la période du réseau électrique suivant l'apparition du défaut.

Lorsqu'un défaut à la terre a été détecté sur l'une des lignes $4_1$ à $4_m$, le dispositif de coupure 5 de la ligne concernée est commandé pour être ouvert.

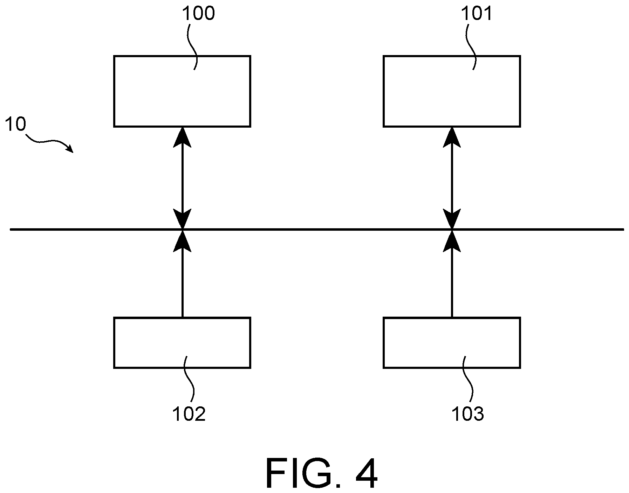

La **figure 4** représente un mode de réalisation particulier du dispositif selon l'invention.

Le dispositif 6 a la structure générale d'un ordinateur. Il comporte notamment un processeur 100 exécutant un programme d'ordinateur mettant en oeuvre le procédé selon l'invention, une mémoire 101, une interface d'entrée 102 et une interface de sortie 103 pour délivrer l'information de détection de défaut et de localisation de défaut à la terre.

Ces différents éléments sont classiquement reliés par un bus.

L'interface d'entrée 102 est destinée à recevoir les valeurs de courant et de tension mesurées.

Le processeur 100 exécute les traitements précédemment exposés en référence à la figure 3. Ces traitements sont réalisés sous la forme d'instructions de code du programme d'ordinateur qui sont mémorisées par la mémoire 101 avant d'être exécutées par le processeur 100.

La mémoire 101 peut en outre mémoriser les résultats des traitements effectués.

L'interface de sortie 103 peut comporter une interface utilisateur pour lui fournir les informations relatives au défaut détecté.

**Revendications**

1. Procédé de détermination directionnelle d'un défaut à la terre dans un réseau de distribution électrique, comportant les étapes de :

   Détermination (E2) d'un phaseur de courant résiduel,
   Détermination (E2) d'un phaseur de tension résiduelle,
   **caractérisé en ce qu'**il comporte les étapes de :

   Détermination (E3) d'un courant actif par projection du phaseur de courant résiduel sur le phaseur de tension résiduelle,
   Détermination (E7) du module de phaseur de tension résiduelle,
   Comparaison (E7) du module de phaseur de tension résiduelle avec un seuil (SVR), et **en ce qu'**il comporte les étapes suivantes, tant que le module de phaseur de tension résiduelle reste supérieur au seuil (SVR) ou à une fraction du seuil (SVR), et pour un nombre prédéterminé d'itérations à partir du moment où le module de phaseur de tension résiduelle est supérieur au seuil (SVR) :

   Détermination (E9, E12) de l'intégrale du courant actif et du signe de l'intégrale du courant actif,
   Détermination (E5) du module du phaseur de courant résiduel,
   Détermination du nombre de fois où le module du phaseur de courant résiduel est supérieur à un seuil prédéterminé (SIR), au cours du nombre prédéterminé d'itérations,
   Si le module du phaseur de courant résiduel est supérieur au seuil prédéterminé (SIR) au moins une fois, au cours du nombre prédéterminé d'itérations,
   Détermination (E16) de la localisation amont ou aval du défaut en fonction du nombre de fois où le signe de l'intégrale du courant actif a été positif ou négatif au cours du nombre prédéterminé d'itérations.

2. Procédé de détermination directionnelle d'un défaut à la terre selon la revendication 1, **caractérisé en ce que** le nombre et la fréquence des itérations sont choisis de sorte que les itérations sont effectuées sur une période réseau.

3. Procédé de détermination directionnelle d'un défaut à la terre selon la revendication 1 ou 2, **caractérisé en ce que** le courant actif est calculé selon la formule :

$$Iactif = \frac{R\acute{e}el(\overrightarrow{IR} \times \overrightarrow{VR^*})}{\left\|\overrightarrow{VR}\right\|}$$

où $\overrightarrow{VR}$ représente le phaseur de tension résiduelle, $\left\|\overrightarrow{VR}\right\|$ le module du phaseur de tension résiduelle et $\overrightarrow{IR}$ le phaseur de courant résiduel.

4. Procédé de détermination directionnelle d'un défaut à la terre selon l'une quelconque des revendications 1 à 3, **caractérisé en ce que** l'intégrale du courant actif est calculée en sommant les valeurs de courant actifs un nombre de fois égal au nombre prédéterminé d'itérations.

5. Procédé de protection d'une ligne de courant lors de l'apparition d'un défaut terre, **caractérisé en ce qu'**il comporte l'actionnement d'un dispositif de coupure de la ligne sur laquelle un défaut terre a été détecté par le procédé de détermination directionnelle d'un défaut à la terre selon l'une des revendications 1 à 4.

6. Dispositif de détermination directionnelle d'un défaut à la terre dans un réseau de distribution électrique, comportant :

Des moyens (600) de détermination d'un phaseur de courant résiduel,
Des moyens (601) de détermination d'un phaseur de tension résiduelle,
**caractérisé en ce qu'**il comporte :

Des moyens (611) de détermination d'un courant actif par projection du phaseur de courant résiduel sur le phaseur de tension résiduelle,
Des moyens (621) de détermination du module de phaseur de tension résiduelle,
Des moyens (622, 622a) de comparaison du module de phaseur de tension résiduelle avec un seuil (SVR),
et **en ce qu'**il comporte les moyens suivants, aptes à fonctionner tant que le module de phaseur de tension résiduelle reste supérieur au seuil (SVR) ou à une fraction du seuil (SVR), et pour un nombre prédéterminé d'itérations à partir du moment où le module de phaseur de tension résiduelle est supérieur au seuil (SVR) :

Des moyens (641) de détermination de l'intégrale du courant actif et du signe de l'intégrale du courant actif,
Des moyens (631) de détermination du module du phaseur de courant résiduel,
Des moyens (631) de détermination du nombre de fois où le module du phaseur de courant résiduel est supérieur à un seuil prédéterminé (SIR), au cours du nombre prédéterminé d'itérations,
Des moyens (644) de détermination de la localisation amont ou aval du défaut en fonction du nombre de fois où le signe de l'intégrale du courant actif a été positif ou négatif au cours du nombre prédéterminé d'itérations, si le module du phaseur de courant résiduel est supérieur au seuil prédéterminé (SIR) au moins une fois, au cours du nombre prédéterminé d'itérations.

7. Indicateur de passage de défaut à la terre **caractérisé en ce qu'**il comporte le dispositif de détermination directionnelle d'un défaut à la terre selon la revendication 6.

8. Dispositif de protection d'une ligne de courant lors de l'apparition d'un défaut terre, **caractérisé en ce qu'**il comporte des moyens d'actionnement d'un dispositif de coupure de la ligne sur laquelle un défaut terre a été détecté par le dispositif de détermination directionnelle d'un défaut à la terre selon la revendication 6.

9. Programme d'ordinateur comportant des instructions pour l'exécution des étapes du procédé selon l'une quelconque des revendications 1 à 5 lorsque ledit programme est exécuté par un ordinateur.

10. Support d'enregistrement lisible par un ordinateur sur lequel est enregistré un programme d'ordinateur comprenant des instructions pour l'exécution des étapes du procédé selon l'une quelconque des revendications 1 à 5.

**Patentansprüche**

1. Verfahren zur Ermittlung der Richtung eines Erdschlusses in einem Stromverteilungsnetz, umfassend die nachfolgenden Schritte:

Ermitteln (E2) eines Reststromzeigers,
Ermitteln (E2) eines Restspannungszeigers,
**dadurch gekennzeichnet, dass** es nachfolgende Schritte umfasst:

Ermitteln (E3) eines Wirkstroms durch Projektion des Reststromzeigers auf den Restspannungszeiger,

Ermitteln (E7) des Restspannungszeigerbetrags,

Vergleichen (E7) des Restspannungszeigerbetrags mit einem Schwellwert (SVR), und dass es die nachfolgenden Schritte umfasst, solange der Restspannungszeigerbetrag höher als der Schwellwert (SVR) oder als ein Bruchteil des Schwellwerts (SVR) bleibt und bei einer vorbestimmten Anzahl von Iterationen ab dem Zeitpunkt, wo der Restspannungszeigerbetrag höher als der Schwellwert (SVR) ist:

> Ermitteln (E9, E12) des Integrals des Wirkstroms und des Vorzeichens des Integrals des Wirkstroms,
> Ermitteln (E5) des Reststromzeigerbetrags,
> Ermitteln der Anzahl, wie oft der Reststromzeigerbetrag im Laufe der vorbestimmten Anzahl von Iterationen höher als ein vorbestimmter Schwellwert (SIR) ist,
> wenn der Reststromzeigerbetrag im Laufe der vorbestimmten Anzahl von Iterationen zumindest einmal höher als der vorbestimmte Schwellwert (SIR) ist,
> Ermitteln (E16) der Lokalisierung des Erdschlusses in Aufwärts- bzw. Abwärtsrichtung in Abhängigkeit von der Anzahl, wie oft das Vorzeichen des Integrals des Wirkstroms im Laufe der vorbestimmten Anzahl von Iterationen positiv oder negativ war.

2. Verfahren zur Ermittlung der Richtung eines Erdschlusses nach Anspruch 1, **dadurch gekennzeichnet, dass** die Anzahl und die Frequenz der Iterationen so gewählt sind, dass die Iterationen über eine Netzperiode erfolgen.

3. Verfahren zur Ermittlung der Richtung eines Erdschlusses nach Anspruch 1 oder 2, **dadurch gekennzeichnet, dass** der Wirkstrom nach der folgenden Formel berechnet wird:

$$Iwirk = \frac{Realteil(\vec{IR} \ x \ \vec{VR}\ *)}{\|\vec{VR}\|}$$

worin $\vec{VR}$ den Restspannungszeiger, $\vec{VR}$ den Restspannungszeigerbetrag und $\vec{IR}$ den Reststromzeiger darstellt.

4. Verfahren zur Ermittlung der Richtung eines Erdschlusses nach einem der Ansprüche 1 bis 3, **da-**

**durch gekennzeichnet, dass** das Integral des Wirkstroms berechnet wird, indem die Wirkstromwerte so oft summiert werden, wie dies der vorbestimmten Anzahl von Iterationen entspricht.

5. Verfahren zum Schutz einer Stromleitung bei Auftreten eines Erdschlusses, **dadurch gekennzeichnet, dass** es die Betätigung einer Abschaltvorrichtung zum Abschalten der Leitung umfasst, auf welcher ein Erdschluss durch das Verfahren zur Ermittlung der Richtung eines Erdschlusses nach einem der Ansprüche 1 bis 4 erfasst wurde.

6. Vorrichtung zur Ermittlung der Richtung eines Erdschlusses in einem Stromverteilungsnetz, enthaltend:

> Einrichtungen (600) zum Ermitteln eines Reststromzeigers,
> Einrichtungen (601) zum Ermitteln eines Restspannungszeigers,
> **dadurch gekennzeichnet, dass** sie enthält:
>
> > Einrichtungen (611) zum Ermitteln eines Wirkstroms durch Projektion des Reststromzeigers auf den Restspannungszeiger,
> > Einrichtungen (621) zum Ermitteln des Restspannungszeigerbetrags,
> > Einrichtungen (622, 622a) zum Vergleichen des Restspannungszeigerbetrags mit einem Schwellwert (SVR),
> > und dass es die nachfolgenden Einrichtungen umfasst, die betriebsbereit sind, solange der Restspannungszeigerbetrag höher als der Schwellwert (SVR) oder ein Bruchteil des Schwellwerts (SVR) bleibt und bei einer vorbestimmten Anzahl von Iterationen ab dem Zeitpunkt, wo der Restspannungszeigerbetrag höher als der Schwellwert (SVR) ist:
> >
> > > Einrichtungen (641) zum Ermitteln des Integrals des Wirkstroms und des Vorzeichens des Integrals des Wirkstroms,
> > > Einrichtungen (631) zum Ermitteln des Reststromzeigerbetrags,
> > > Einrichtungen (631) zum Ermitteln der Anzahl, wie oft der Reststromzeigerbetrag im Laufe der vorbestimmten Anzahl von Iterationen höher als ein vorbestimmter Schwellwert (SIR) ist,
> > > Einrichtungen (644) zum Ermitteln der Lokalisierung des Erdschlusses in Aufwärts- bzw. Abwärtsrichtung in Abhängigkeit von der Anzahl, wie oft das Vorzeichen des Integrals des Wirkstroms im Laufe der vorbestimmten Anzahl von Iterationen positiv oder negativ war, wenn der Reststromzeigerbetrag im Laufe der vorbestimmten Anzahl an Iterationen zumindest einmal höher als der vorbestimmte Schwellwert (SIR) ist.

7. Erdschlussübergangsindikator, **dadurch gekennzeichnet, dass** er die Vorrichtung zur Ermittlung der Richtlung eines Erdschlusses nach Anspruch 6 enthält.

8. Vorrichtung zum Schutz einer Stromleitung bei Auftreten eines Erdschlusses, **dadurch gekennzeichnet, dass** sie Einrichtungen zur Betätigung einer Abschaltvorrichtung zum Abschalten der Leitung umfasst, auf welcher ein Erdschluss über die Vorrichtung zur Ermittlung der Richtung eines Erdschlusses nach Anspruch 6 erfasst wurde.

9. Computerprogramm, umfassend Anweisungen zum Durchführen der Schritte des Verfahrens nach einem der Ansprüche 1 bis 5, wenn das Programm auf einem Computer ausgeführt wird.

10. Computerlesbarer Aufzeichnungsträger, auf dem ein Computerprogramm abgespeichert ist, das Anweisungen zum Durchführen der Schritte des Verfahrens nach einem der Ansprüche 1 bis 5 umfasst.

**Claims**

1. Method for the directional determination of an earth fault in an electric power distribution network, comprising the steps of:

   Determining (E2) a residual current phasor,
   Determining (E2) a residual voltage phasor,
   **characterised in that** it comprises the steps of:

   Determining (E3) an active current by projection of the residual current phasor on the residual voltage phasor,
   Determining (E7) of the residual voltage phasor module,
   Comparing (E7) the residual voltage phasor module with a threshold (SVR),
   and **in that** it comprises the following steps, as long as the residual voltage phasor module remains higher than the threshold (SVR) or a fraction of the threshold (SVR), and for a predetermined number of iterations starting from the moment when the residual voltage phasor module is greater than the threshold (SVR):

   Determining (E9, E12) the integral of the active current and of the sign of the integral of the active current,
   Determining (E5) the residual current phasor module,
   Determining the number of times when the residual current phasor module is greater than a predetermined threshold (SIR), during the predetermined number of iterations,
   If the residual current phasor module is greater than the predetermined threshold (SIR) at least one time, during the predetermined number of iterations,
   Determining (E16) the location upstream or downstream of the defect according to the number of times when the sign of the integral of the active current was positive or negative during the predetermined number of iterations.

2. Method for the directional determination of an earth fault according to claim 1, **characterised in that** the number and the frequency of the iterations are chosen in such a way that the iterations are carried out over one network period.

3. Method for the directional determination of an earth fault according to claim 1 or 2, **characterised in that** the active current is calculated according to the formula:

$$Iactif = \frac{\mathrm{Re}\,al(\overrightarrow{IR} \times \overrightarrow{VR*})}{\left\|\overrightarrow{VR}\right\|}$$

where $\overrightarrow{VR}$ represents the residual voltage phasor, $\left\|\overrightarrow{VR}\right\|$ the module of the residual voltage phasor and $\overrightarrow{IR}$ the residual current phasor.

4. Method for the directional determination of an earth fault according to any of claims 1 to 3, **characterised in that** the integral of the active current is calculated by adding together the active current values a number of times equal to the predetermined number of iterations.

5. Method for protecting a current line during the appearance of an earth fault, **characterised in that** it comprises the actuating of a device for cutting off the line whereon an earth fault has been detected by the method for the directional determination of an earth fault according to one of claims 1 to 4.

6. Device for the directional determination of an earth fault in an electric power distribution network, comprising:

   Means (600) for determining a residual current phasor,
Means (601) for determining a residual voltage phasor,
**characterised in that** it comprises:

Means (611) for determining an active current by projection of the residual current phasor on the residual voltage phasor,
Means (621) for determining the residual voltage phasor module,
Means (622, 622a) for comparing the residual voltage phasor module with a threshold (SVR),
and **in that** it comprises the following means, able to operate as long as the residual voltage phasor module remains higher than the threshold (SVR) or a fraction of the threshold (SVR), and for a predetermined number of iterations starting from the moment when the residual voltage phasor module is greater than the threshold (SVR):

Means (641) for determining the integral of the active current and of the sign of the integral of the active current,
Means (631) for determining the residual current phasor module,
Means (631) for determining the number of times when the residual current phasor module is greater than a predetermined threshold (SIR), during the predetermined number of iterations,
Means (644) for determining the location upstream or downstream of the defect according to the number of times when the sign of the integral of the active current was positive or negative during the predetermined number of iterations, if the residual current phasor module is greater than the predetermined threshold (SIR) at least one time, during the predetermined number of iterations.

7. Passage indicator of earth fault **characterised in that** it comprises the device for the directional determination of an earth fault according to claim 6.

8. Device for protecting a current line during the appearance of an earth fault, **characterised in that** it comprises means for actuating a device for cutting off the line whereon an earth fault has been detected by the device for directional determination of an earth fault according to claim 6.

9. Computer programme comprising instructions for the execution of the steps of the method according to any of claims 1 to 5 when said programme is executed by a computer.

10. Recording support that can be read by a computer whereon is recorded a computer programme that comprises instructions for executing the steps of the method according to any of claims 1 to 5.

FIG. 1

EP 3 001 524 B1

FIG. 2

E1

E2 E6

E3

E4

E5

E7

E8

E9

E10

E11 E13

E12

E14

E16

E15

| IA,IB,IC,VA,VB,VC |

| $\overrightarrow{IR}$  $\overrightarrow{VR}$ |

| Iactif |

| IRvalid |

FVR=0 ?

N

Y

$\|\overrightarrow{IVR}\|>$ SVR

N

Y

$\|\overrightarrow{IVR}\|<$ 0,75.SVR

N

Y

| Integral = Integral + Iactif<br>k = k+1<br>SD(k) |

FVR=1

| k=1<br>Intégral   SD(k) |

| FVR=0 |

k≥5

Y

N

| ValidationIR |

ValidationIR >0

Y

N

N

Y

FIG. 3

FIG. 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0591011 A
- EP 0845846 A
- EP 2624397 A
- US 5661664 A
- US 2010301872 A
- EP 2533060 A
- EP 2306609 A